Europäisches Patentamt

European Patent Office

Office européen des brevets

(11) Numéro de publication : **0 319 475 B1**

(12) **FASCICULE DE BREVET EUROPEEN**

(19)

(45) Date de publication du fascicule du brevet :
06.05.92 Bulletin 92/19

(21) Numéro de dépôt : **88810802.4**

(22) Date de dépôt : **23.11.88**

(51) Int. Cl.$^5$ : **H03H 9/19**, G04F 5/06

(54) **Résonateur piézoélectrique.**

(30) Priorité : **02.12.87 FR 8716733**

(43) Date de publication de la demande :
**07.06.89 Bulletin 89/23**

(45) Mention de la délivrance du brevet :
**06.05.92 Bulletin 92/19**

(84) Etats contractants désignés :
**AT BE CH DE ES FR GB GR IT LI LU NL SE**

(56) Documents cités :
**EP-A- 0 086 739**
**US-A- 4 253 036**
**PROCEEDINGS OF THE 39TH ANNUAL FRE-**
**QUENCY SYMPOSIUM 1985, Philadelphia,**
**Pennsylvania, 29-31 mai 1985, pages 375-380,**
**IEEE, NewYork, US; J.W. HERMANN: "A novel**
**miniature ZT-cut resonator"**

(73) Titulaire : **CENTRE ELECTRONIQUE**
**HORLOGER S.A.**
**Maladière 71**
**CH-2000 Neuchâtel 7 (CH)**

(72) Inventeur : **Bourgeois, Claude**
**Ministre 4**
**CH-2014 Bôle (CH)**

(74) Mandataire : **Brulliard, Joel**
**c/o CENTRE SUISSE D'ELECTRONIQUE ET DE**
**MICROTECHNIQUE S.A. Maladière 71**
**CH-2007 Neuchâtel (CH)**

Jouve, 18, rue Saint-Denis, 75001 PARIS

EP 0 319 475 B1

## Description

La présente invention a pour objet un résonateur piézoélectrique comportant deux plaques, au moins deux barreaux parallèles reliant lesdites plaques l'une à l'autre, et des moyens pour exciter une vibration dudit résonateur dans un premier mode de contour.

La demande de brevet EP-A-0086739 décrit un résonateur comprenant des plaques réunies par des bras résonnants, réalisé dans une plaquette de quartz de coupe ZT et vibrant dans son plan.

Cette coupe est définie, par exemple, dans le brevet CH-A-623690, et ne sera donc pas rappelée ici.

Ce résonateur est excité dans un mode d'allongement et sa coupe est telle qu'aucun autre mode de vibration n'est couplé à ce mode d'allongement à la température d'utilisation.

La longueur des bras de ce résonateur est déterminée de manière que leur fréquence de résonance, lorsqu'ils sont entraînés par les plaques, soit égale à celle de ces dernières.

La coupe ZT de ce résonateur permet d'obtenir de très bonnes propriétés thermiques et le rend fabricable par des techniques de production de masse, telles les techniques d'attaque chimique. Grâce à sa forme, il peut être aisément fixé à un boîtier par l'intermédiaire d'une zone d'encastrement. Toutefois, comme il sera vu ci-après, la fréquence de travail et/ou les dimensions de ce résonateur le rendent peu propice à des applications où aussi bien le faible encombrement que la faible consommation sont requis.

En effet, pour un barreau mince de longueur l vibrant en allongement, sa fréquence f est liée à sa longueur par la relation $f.l = C/2$; où C représente la vitesse de propagation des oscillations dans le barreau. Dans le cas du résonateur mentionné précédemment, la longueur des plaques et celle des barreaux étant approximativement égales, la longueur L de ce résonateur est alors liée à sa fréquence par la relation $f.L = 3C/2$

Il en découle que, pour une fréquence de résonance f donnée, la longueur totale L du résonateur est assez grande, ou que, pour une longueur totale L donnée, la fréquence de résonnance f du résonateur est assez élevée.

Or il existe de nombreux dispositifs utilisant des résonateurs piézoélectriques, notamment les pièces d'horlogerie électroniques de petit volume telles que les montres-bracelet, dans lesquels ce résonateur doit avoir des dimensions aussi petites que possible et une fréquence de résonance pas trop élevée pour que les circuits électroniques associés à ce résonateur ne consomment pas trop d'énergie électrique.

Du fait de la relation mentionnée ci-dessus entre sa longueur totale L et sa fréquence de résonance f, le résonateur décrit ci-dessus n'est pas idéal pour être utilisé dans de tels dispositifs.

Un objet de la présente invention est un résonateur piézoélectrique qui ne présente pas les inconvénients mentionnés ci-dessus.

Un autre objet de l'invention est un résonateur ayant de bonnes propriétés thermiques, vibrant selon des modes de contour, aisément usinable chimiquement, encastrable, et dont le produit de la fréquence par la longueur totale est plus faible que celui des résonateurs de l'art antérieur.

Ces objets sont réalisés par le résonateur revendiqué, grâce au fait que les moyens d'excitation de sa vibration dans un premier mode de contour sont agencés de manière à exciter cette vibration dans les barreaux qu'il comporte, et que sa coupe et ses dimensions sont déterminées de manière qu'au moins un deuxième mode de contour, différent de ce premier mode, soit couplé à ce dernier.

D'autres buts, caractéristiques et avantages du résonateur selon l'invention seront rendus évidents par la description qui va être faite maintenant de quelques formes d'exécution de ce résonateur représentées à titre d'exemples non limitatifs par les dessins annexés dans lesquels :

– la figure 1 est une vue en plan schématique d'une forme d'exécution du résonateur selon l'invention;

– la figure 2 est une coupe schématique du résonateur de la figure 1 réalisée selon l'axe A-A de cette figure 1;

– La figure 3 est une vue en plan schématique d'une autre forme d'exécution du résonateur selon l'invention;

– les figures 4 et 5 sont des coupes schématiques du résonateur de la figure 3 réalisées respectivement selon les axes B-B et C-C de cette figure 3;

– la figure 6 est une vue en plan schématique d'une autre forme d'exécution du résonateur selon l'invention;

– la figure 7 est une coupe schématique du résonateur de la figure 6 réalisée selon l'axe D-D de cette figure 6; et

– La figure 8 est une vue en plan schématique d'une autre forme d'exécution du résonateur selon l'invention.

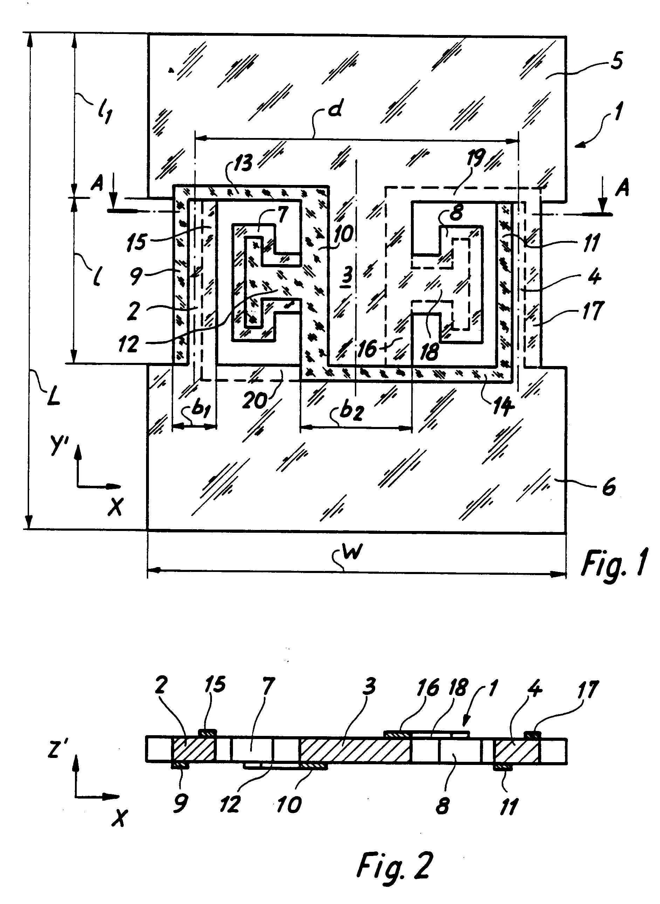

Dans la forme d'exécution dont une vue en plan est représentée à la figure 1 et une vue en coupe, selon l'axe A-A de cette figure 1, est représentée à la figure 2, le résonateur selon l'invention est désigné par la référence 1.

Ce résonateur 1 comporte trois barreaux parallélépipédiques 2, 3 et 4 disposés parallèlement les uns aux

2

autres et deux plaques rectangulaires 5 et 6 reliées chacune à une extrémité des barreaux 2, 3 et 4 de manière que le milieu de la largeur de ces plaques 5 et 6 coïncide avec l'axe longitudinal du barreau médian 3.

Le résonateur 1 comporte en outre deux bras de fixation 7 et 8 disposés de part et d'autre du barreau médian 3, sensiblement au milieu de sa longueur.

Tous les éléments 2 à 8 qui viennent d'être décrits ne forment qu'une seule et même pièce qui a été découpée, à l'aide d'une technique photolithographique connue en soi, dans une plaquette mince en quartz.

Cette plaquette a été taillée de manière que son plan soit parallèle à l'axe piézoélectrique X du quartz et perpendiculaire à une axe Z′ faisant un angle de 2° avec l'axe optique Z du quartz. Une telle plaquette est généralement désignée comme étant de coupe X+2°.

Le résonateur 1 a été ensuite découpé dans cette plaquette de manière que sa largeur W soit parallèle à l'axe X du quartz; sa longueur L étant parallèle à un axe Y′, perpendiculaire à cet axe X et à l'axe Z′ mentionné ci-dessus.

Dans la suite de cette description, la face du résonateur 1, ou de ses éléments, qui est visible dans la figure 1 sera appelée arbitrairement première face, et celle qui n'est pas visible sera appelée deuxième face. Il en sera de même pour les autres résonateurs qui seront décrits plus loin.

Le résonateur 1 porte sur sa première face une première électrode en trois parties 9, 10 et 11, disposées respectivement sur le bord de gauche des trois barreaux 2, 3, et 4.

La partie 10 de cette électrode est reliée électriquement à une borne de connexion 12 disposée sur le bras de fixation 7. Elle est également reliée aux parties 9 et 11 par des pistes conductrices 13 et 14 respectivement disposées sur les plaques 5 et 6.

Le résonateur 1 porte, sur sa deuxième face, une deuxième électrode en trois parties 15, 16 et 17, disposées, respectivement, sur le bord de droite desdits trois barreaux 2, 3 et 4.

La partie 16 de cette électrode est reliée électriquement à une borne de connexion 18 disposée sur le bras de fixation 8. Elle est également reliée aux parties 15 et 17 par des pistes conductrices 19 et 20 respectivement disposées sur les plaques 5 et 6.

Les électrodes 9 à 11 et 15 à 17, les bornes de connexion 12 et 18 et les pistes conductrices 13, 14, 19 et 20 sont constituées par des couches métalliques, réalisées, de manière connue, pendant la fabrication du résonateur.

Il faut noter que chacune des bornes de connexion 12 et 18 pourrait occuper toute la surface du bras de fixation 7 ou 8 sur lequel elle est disposée. De même ces bornes de connexion 12 et 18 pourraient être respectivement disposées sur la première et sur la deuxième face du même bras de fixation. De telles formes d'exécution du résonateur 1 n'ont pas été représentées.

Les bras de fixation 7 et 8 sont destinés à être reliés à un support, faisant partie d'un boîtier non représenté, et sont situés au milieu de la longueur du barreau 3. Ils constituent une zone d'évanescence des mouvements et déformations du résonateur.

La configuration d'électrodes décrite ci-dessus permet, à l'aide d'un oscillateur adéquat, d'exciter un mode d'allongement des barreaux du résonateur par le biais de la composante du champ électrique qui est parallèle à l'axe X et dans le plan du résonateur.

Comme les barreaux 2 à 4 sont chargés par les plaques 5 et 6, le produit de la fréquence f du résonateur 1 par sa longueur L peut être beaucoup plus faible que pour le résonateur de l'art antérieur mentionné précédemment. Ce produit peut s'exprimer par la relation: $f.L = K. C/2$

On voit qu'il est avantageux de choisir un facteur K aussi faible que possible, car plus il est faible et plus la longueur totale L du résonateur 1 est faible pour une fréquence de résonnance f donnée, ou plus la fréquence de résonance f du résonateur est basse pour une longueur totale L donnée.

A titre d'exemple, pour un résonateur tel que le résonateur 1 destiné à vibrer à une fréquence d'environ 500 kHz, on peut choisir pour le facteur K une valeur aussi faible que 0,7.

A cette valeur, correspond une longueur totale du résonateur 1 de l'ordre de 4 millimètres, qui est encore acceptable dans la plupart des applications.

On voit donc que, à longueurs égales, la fréquence de résonance du résonateur 1 est plus de quatre fois plus basse que celle du résonateur connu mentionné précédemment.

Cet avantage important du résonateur 1 par rapport au résonateur connu permet de l'utiliser beaucoup plus facilement que ce dernier dans les dispositifs mentionnés ci-dessus où la place disponible est très limitée et, surtout, où la consommation d'énergie électrique doit être la plus faible possible.

Il faut noter que la forme des différents éléments du résonateur 1 (plaques et barreaux), pourrait être différente de celle, rectangulaire, qu'ils ont dans la figure 1.

On sait que le comportement en température d'un résonateur à quartz peut être valablement représenté par le polynôme du 3e degré suivant :

$$f = fo [ 1 + \alpha (t-t_o) + \beta (t-t_o)^2 + \gamma (t-t_o)^3 ],$$

où t représente la température en degré celsius, fo la fréquence du résonateur à la température $t_o$ et $\alpha$, $\beta$ et $\gamma$ représentent respectivement les coefficients de température du premier, du deuxième et du troisième ordre.

La valeur des coefficients $\alpha$, $\beta$, et $\gamma$ dépend de la coupe du quartz et des dimensions des divers éléments du résonateur.

Le résonateur 1 étant réalisé dans une plaquette de quartz de coupe X + 2° et vibrant dans un mode d'allongement, le coefficient $\alpha$ mentionné ci-dessus est très proche de zéro.

Par ailleurs, selon l'invention, les dimensions des différents éléments du résonateur 1 sont choisies de manière que le mode d'allongement des barreaux 2 à 4 soit couplé élastiquement avec un mode de flexion des barreaux et des plaques 5 et 6 ayant une fréquence de résonance voisine de celle de ce mode d'allongement. Grâce à ce couplage, il est possible d'obtenir une valeur très faible du coefficient de deuxième ordre ß. La distance d, qui sépare les axes des barreaux externes 2 et 4 ou la largeur W des plaques 5 et 6 peuvent être utilisées comme paramètres pour modifier le couplage entre les modes d'allongement et de flexion et, par suite, améliorer les propriétés thermiques du résonateur 1.

A titre d'exemple, le résonateur décrit ci-dessus présente les caractéristiques suivantes:

| | |
|---|---|
| coupe: | X + 2° |
| fréquence: | $2^{19}$ Hz |
| longeur totale L: | 3,70 mm |
| largeur totale w: | 2,75 mm |
| épaisseur: | 0,1 à 0,2 mm |
| longeur des bras l: | 1,20 mm |
| largeur des bras extérieurs bl: | 0,30 mm |
| largeur des bras médians B2: | 0,27 mm |
| distance entre les axes des bras extérieurs d: | 1,45 mm |

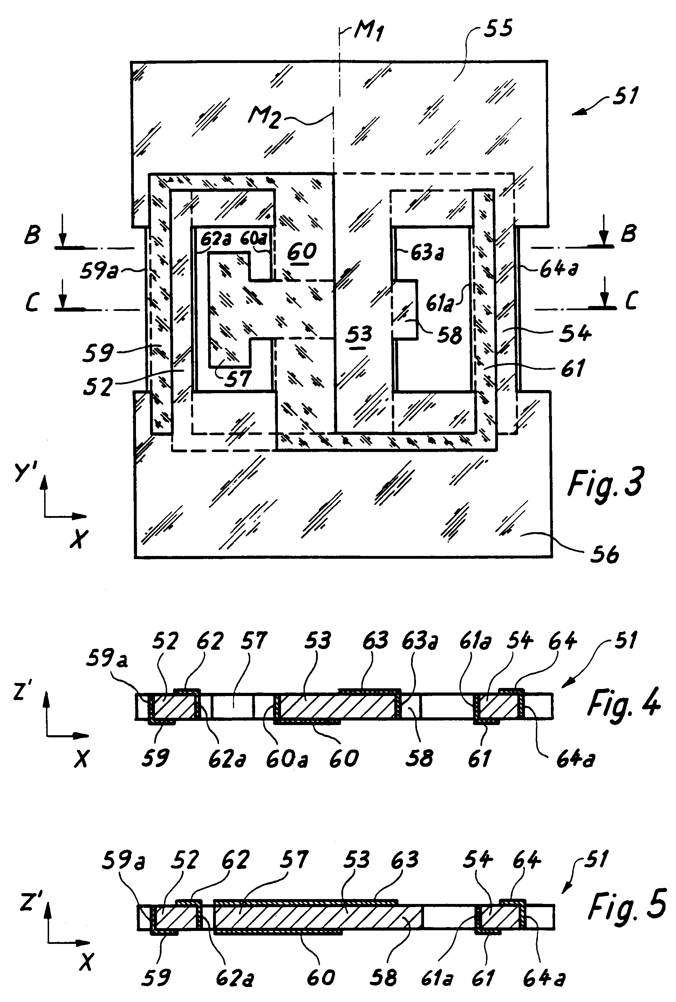

Le résonateur 51 représenté en plan à la figure 3 et en coupe aux figures 4 et 5, ces coupes étant respectivement faites selon les axes B-B et C-C de la figure 3, a une forme générale semblable à celle du résonateur 1 des figures 1 et 2.

Comme ce dernier, il a été découpé dans une plaquette de quartz de coupe X + 2°, et il comporte trois barreaux parallèles 52, 53 et 54, et deux plaques rectangulaires 55 et 56 reliées aux extrémités des barreaux 52, 53 et 54.

Le résonateur 51 présente donc le même avantage que le résonateur 1 par rapport au résonateur connu décrit ci-dessus, c'est-à-dire que sa fréquence de résonance peut être beaucoup plus faible, à dimensions égales, que celle de ce dernier, ou que sa longueur totale peut être beaucoup plus petite, à fréquence de résonance égale, que celle de ce résonateur connu.

Les figures 3 à 5 montrent que le résonateur 51 ne comporte qu'un seul bras de fixation, désigné par 57, qui est relié au barreau 53 au milieu de la longueur de ce dernier, et qui est destiné à être fixé à un support, non représenté, faisant partie d'un boîtier, également non représenté.

A la place occupée par le bras de fixation 8 dans le résonateur 1, le résonateur 51 ne comporte qu'une simple plaquette rectangulaire 58 qui, contrairement au bras de fixation 57, n'est pas destinée à être fixée à un support.

Le bras de fixation 57 et la plaquette 58 ne forment bien entendu qu'une seule et même pièce avec le barreau 53, et donc avec le reste du résonateur 51.

Le fait que le résonateur 51 soit fixé de manière asymétrique par le seul bras de fixation 57 et la présence de la plaque 58 permettent de compenser les dissymétries que peut engendrer, par exemple, un procédé de fabrication par attaque chimique.

Il est également possible, pour compenser les effets résultants de l'attaque chimique et notamment pour améliorer le facteur de qualité du résonateur, de décaler légèrement la position des barreaux 52, 53 et 54 par rapport à l'axe médian des plaques 55 et 56. Ce décalage apparaît sur la figure 3 où M1 représente la position de l'axe médian des plaques 55 et 55 et M2, celle de l'axe médian des barreaux 52 à 54.

Il est évident que les mesures qui viennent d'être décrites ne doivent pas toujours être prises simultanément mais que, selon les cas, l'une ou l'autre, seulement, peut être appliquée.

Le résonateur 51 porte, sur sa première face, une première électrode en trois parties 59, 60 et 61 disposées respectivement sur le bord gauche des barreaux 52, 53 et 54, et, sur sa deuxième face, une deuxième électrode en trois parties 62, 63 et 64 disposées respectivement sur le bord droit de ces barreaux.

Cette disposition des électrodes 59 à 64 est donc analogue à celle des électrodes 9 à 11 et 15 à 17 du résonateur 1. On voit cependant dans les figures 3 à 5 que, par rapport à la largeur de ces dernières électrodes, la largeur des électrodes 59 à 64 a été augmentée, de sorte que chacune d'entre elle occupe la moitié de la largeur du barreau sur lequel elle est disposée.

En outre, toujours par rapport aux électrodes 9 à 11 et 15 à 17, la longueur des électrodes 59 à 64 a été également augmentée, de sorte qu'elles s'étendent sur une partie des plaques 55 et 56.

Ces deux mesures, qui peuvent être prises indépendamment l'une de l'autre, ont chacune pour effet d'augmenter le facteur de couplage piézoélectrique du résonateur 51 par rapport à celui du résonateur 1; les modes de vibration, dimensions et propriétés thermiques étant, par ailleurs, identiques pour les deux résonateurs.

Les figures 3 à 5 illustrent une troisième mesure qui peut être prise, seule ou en combinaison avec les autres mesures mentionnées ci-dessus, pour augmenter encore la valeur du facteur de couplage piézoélectrique.

Cette mesure consiste à munir le résonateur 51 des électrodes latérales 59a à 64a qui sont disposées chacune sur un des flancs de l'un des barreaux 52 à 54 et qui sont reliées chacune à celle des électrodes 59 à 64 qui lui est adjacente.

Bien que les précédentes formes d'exécution aient été décrites dans le cadre d'une coupe X + 2°, d'autres coupes peuvent également être utilisées. Toutefois, il conviendra de tenir compte, dans le choix de la coupe du cristal, de critères tels que: couplage piézoélectrique suffisant pour exciter le mode d'allongement des barreaux, valeur des coefficients de température ou facilité de la découpe chimique.

Parmi les orientations possibles, on peut à titre d'exemple non limitatif celles qui sont désignées sous le nom de coupe ZT ou GT, ainsi que celles semblables à celle qui a été utilisée pour le résonateur 1 de la figure 1, dans lesquelles le plan de la plaquette est parallèle à l'axe X du quartz et dans lesquelles la normale à ce plan fait un angle compris entre - 10° et + 10° environ avec l'axe Z du quartz.

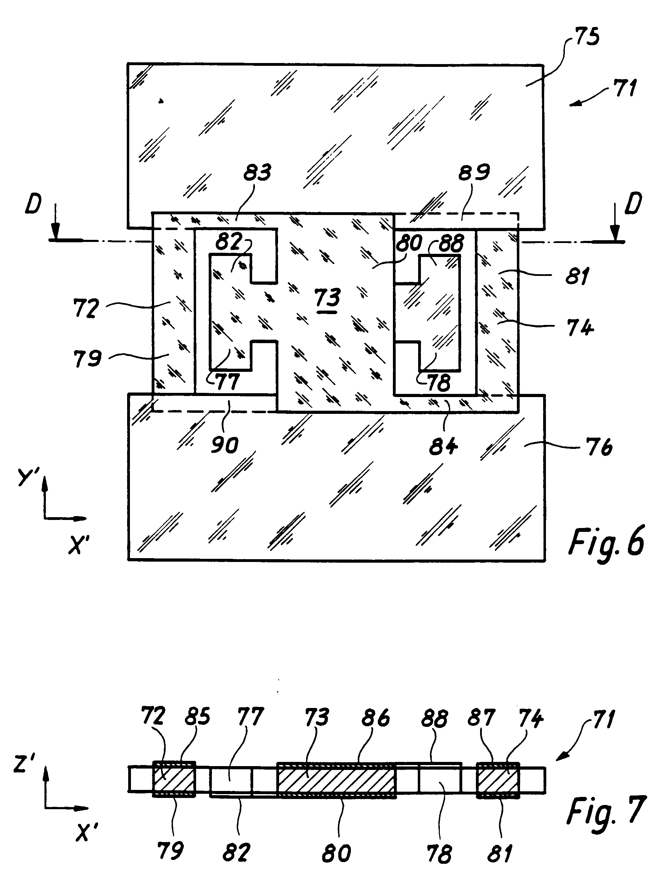

Dans la forme d'exécution représentée par les figures 6 et 7 le résonateur selon l'invention, désigné par 71, a été découpé dans une plaquette de quartz de coupe ZT.

Cette coupe ZT est connue, notamment par le brevet CH-A-623690 et ne sera pas décrite ici.

Comme la résonateur 1 des figures 1 et 2, le résonateur 71 comporte trois barreaux parallèles 72, 73 et 74 reliés à deux plaques rectangulaires 75 et 76.

Le résonateur 71 comporte en outre deux bras de fixation 77 et 78 disposés sensiblement au milieu de la longueur du barreau médian 73.

Les trois parties 79, 80 et 81 d'une première électrode occupent respectivement la totalité de la première face des barreaux 72, 73 et 74.

Une borne de connexion 82 est disposée sur la première face du bras de fixation 77 et les différentes parties de la première électrode sont reliées entre elles par des pistes conductrices 83 et 84 disposées sur la première face des plaques 75 et 76.

Les trois parties 85, 86 et 87 d'une deuxième électrode occupent respectivement la totalité de la deuxième face des barreaux 72, 73 et 74.

Une borne de connexion 88 est disposée sur la deuxième face du bras de fixation 78 et les différentes parties de la deuxième électrode sont reliées entre elle par deux pistes conductrices 89 et 90 disposées sur la deuxième face des plaques 75 et 76.

Lorsque les bornes de connexion 82 et 88 sont reliées à un circuit oscillateur adéquat, les barreaux 72 et 74 vibrent dans un mode d'allongement en réponse au champ électrique alternatif qui leur est appliqué par les électrodes 79 à 82 et 85 à 87.

Comme dans le résonateur 1, la fréquence de résonance des barreaux 72 à 74 est diminuée par l'inertie des plaques 75 et 76 qui leur sont reliées.

Le résonateur 71 présente donc le même avantage que le résonateur 1 par rapport au résonateur connu mentionné ci-dessus.

Les considérations qui ont été faites ci-dessus à propos de la détermination des dimensions du résonateur 1 en fonction des caractéristiques que celui-ci doit avoir s'appliquent évidemment au résonateur 71, et aux autres résonateurs du même genre qui peuvent être réalisés à partir de plaquettes de quartz de coupe autre que celles qui ont été décrites.

Il en de même des modifications qui ont été décrites en liaison avec les figures 3 à 5 et qui ont pour effet d'augmenter le facteur de qualité des résonateurs selon l'invention.

En ce qui concerne les autres modifications décrites en liaison avec les figures 3 à 5, leur application dépend bien entendu de la disposition des électrodes sur les barreaux du résonateur, disposition qui dépend elle-même de l'orientation du résonateur par rapport aux axes X, Y et Z du quartz.

Ainsi, par exemple, dans le cas du résonateur 71 des figures 6 et 7, la seule mesure qui peut être prise, pratiquement, pour augmenter le couplage piézoélectrique est celle qui consiste à prolonger les électrodes 79 à 81 et 85 à 87 de manière qu'elles s'étendent sur une partie des plaques 75 et 76. Dans un tel cas, il est alors avantageux de prolonger les pistes conductrices 83, 84, 89 et 90 de manière à relier directement les deux extrémités des parties d'électrodes 79 et 81 et, respectivement, 85 et 87. Ces pistes conductrices contribuent alors elles-mêmes au couplage piézoélectrique du résonateur.

5

Les principes qui servent de base à la présente invention peuvent également s'appliquer pour réaliser des résonateurs ayant une structure différente de celle des résonateurs qui viennent d'être décrits.

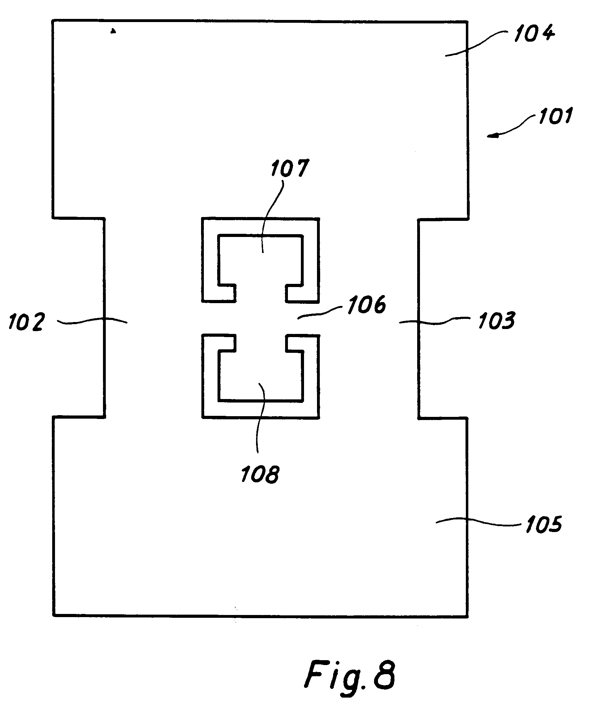

Ainsi, par exemple, la figure 8 représente un résonateur 101, vu en plan, qui ne comporte que deux barreaux 102 et 103.

Le résonateur 101 a été découpé dans une plaquette de quartz ayant l'une quelconque des orientations, par rapport aux axes X, Y et Z du quartz, qui conviennent à la réalisation de résonateurs vibrant dans un mode d'allongement.

Le résonateur 101 comporte également deux plaques rectangulaires 104 et 105 qui sont reliées aux extrémités des barreaux 102 et 103.

Ces barreaux 102 et 103 sont en outre reliés par une barre transversale 106 située sensiblement au milieu de leur longueur.

Cette barre transversale 106 porte deux bras de fixation 107 et 108 analogues aux bras de fixation 7 et 8 du résonateur 1 et destinés comme ces derniers à être fixé à un support faisant partie d'un boîtier.

Des électrodes sont disposées sur les barreaux 102 et 103 de manière que, lorsqu'elles sont reliés à un circuit oscillateur adéquat, ces barreaux vibrent dans un mode d'allongement, comme dans le cas des résonateurs décrits ci-dessus.

Ces électrodes n'ont pas été représentées, car leur disposition sur les barreaux 102 et 103 dépend de l'orientation par rapport aux axes X, Y et Z du quartz de la plaquette dans laquelle le résonateur 101 a été découpé.

Des pistes conductrices, qui n'ont pas non plus été représentées, relient ces électrodes à des bornes de connexion également non représentées, disposées sur les bras de fixation 107 et 108.

Excité sur un mode d'allongement des barreaux 102 et 103, le résonateur 101 présentera également un produit fréquence par longueur plus faible que ceux des résonateurs connus mentionnés précédemment. Sa coupe et ses dimensions seront déterminées de manière qu'il possède un mode de flexion couplé à son mode d'allongement et ayant une fréquence de résonance proche de celle de ce mode d'allongement.

On cherchera également a obtenir une valeur des coefficients $\alpha$ et $\beta$ voisine et zéro et du coefficient $\gamma$ aussi faible que possible, de sorte que la variation de sa fréquence de résonance en fonction de la température peut être très faible.

Dans toutes les formes d'exécution qui ont été décrites ci-dessus, les électrodes d'excitation de la vibration du résonateur sont disposées sur ce dernier de manière qu'il vibre dans un mode d'allongement. On a vu en outre que la coupe et les dimensions de ce résonateur peuvent être déterminées de manière qu'un mode de flexion soit couplé à ce mode d'allongement, pour diminuer la variation de fréquence de résonance en fonction de la température.

Il est évident que d'autres formes d'exécution du résonateur selon l'invention peuvent être réalisées.

Dans ces autres formes d'exécution, qui ne seront pas décrites en détail car leur réalisation ne pose pas de problème particulier au vu des explications qui ont été données ci-dessus, le résonateur selon l'invention a la même forme générale que l'un de ceux qui ont été décrits ci-dessus.

Cependant, les électrodes d'excitation de sa vibration sont disposées de manière qu'il vibre dans un autre mode de contour, par exemple un mode de flexion ou de cisaillement de surface.

Dans un tel cas, il est également possible de déterminer les dimensions du résonateur de manière qu'un mode de contour différent, par exemple un mode d'allongement, soit couplé à son mode de vibration principal, toujours dans le but de diminuer la variation de sa fréquence de résonance en fonction de la température.

Il est également évident que des matériaux piézoélectriques autres que le quartz peuvent être utilisés pour réaliser le résonateur selon l'invention.

## Revendications

1. Résonateur piézoélectrique comportant deux plaques, au moins deux barreaux parallèles reliant lesdites plaques l'une à l'autre, et des moyens pour exciter une vibration dudit résonateur dans un premier mode de contour, caractérisé par le fait que lesdits moyens sont agencés de manière à exciter ladite vibration dans lesdits barreaux et que la coupe et les dimensions dudit résonateur sont déterminées de manière qu'au moins un deuxième mode de vibration de contour, différent dudit premier mode de vibration, soit couplé audit premier mode de vibration.

2. Résonateur selon la revendication 1, caractérisé par le fait que ledit premier mode de vibration est un mode d'allongement et ledit deuxième mode est un mode de flexion.

3. Résonateur selon l'une des revendications 1 et 2, caractérisé par le fait qu'il a été découpé dans une plaquette plane en quartz dont le plan est parallèle à l'axe piézoélectrique X dudit quartz, la normale audit plan

6

faisant avec l'axe optique Z dudit quartz un angle compris entre - 10° et + 10° environ et la longueur desdits barreaux ayant une direction perpendiculaire audit axe X, et par le fait que lesdits moyens d'excitation comportant des électrodes disposées sur les faces desdits barreaux qui sont parallèles audit axe X de manière à produire un champ électrique ayant une composante parallèle audit axe X.

4. Résonateur selon l'une des revendications 1 à 3, caractérisé par le fait qu'il a été découpé dans une plaquette plan en quartz dont le plan est parallèle à l'axe piézoélectrique X dudit quartz, la normale audit plan faisant avec l'axe optique Z dudit quartz un angle compris entre 0 et ± 10° environ et la longueur desdits barreaux ayant une direction perpendiculaire audit axe X, et par le fait que lesdits moyens d'excitation comportent des électrodes disposées sur les flancs desdits barreaux perpendiculairement audit axe X pour produire un champ électrique parallèle audit axe X.

5. Résonateur selon l'une des revendications 1 et 2, caractérisé par le fait qu'il a été découpé dans une plaquette de coupe ZT de manière que la longueur desdits barreaux soit parallèle à l'axe X' de ladite plaquette, et par le fait que lesdits moyens d'excitation comportent des électrodes disposées, chacune, sur toute la surface de l'une des faces desdits barreaux qui sont parallèles aux axes X' et Y' de ladite plaquette.

6. Résonateur selon l'une des revendications 3 et 5, caractérisé par le fait que lesdites électrodes s'étendent en outre sur une partie desdites plaques.

7. Résonateur selon l'une quelconque des revendications 1 à 6, caractérisé par le fait qu'il comporte trois barreaux parallèles.

8. Résonateur selon l'une quelconque des revendications 1 à 6, caractérisé par le fait qu'il comporte deux barreaux parallèles.


**Patentansprüche**

1. Piezoelektrischer Resonator, umfassend zwei Platten, mindestens zwei parallele, die beiden Platten miteinander verbindende Säulen und Mittel zum Erregen einer Vibration des Resonators in einem ersten Konturmodus, **dadurch gekennzeichnet**, daß die Mittel derart ausgebildet sind, daß die Vibration in den Säulen angeregt wird und daß der Schnitt und die Abmessungen des Resonators derart festgelegt sind, daß mindestens ein zweiter Vibrationskonturmodus, der von dem ersten Vibrationsmodus abweicht, mit dem ersten Vibrationsmodus gekoppelt ist.

2. Resonator nach Anspruch 1, dadurch gekennzeichnet, daß der erste Vibrationsmodus ein Längsmodus ist und der zweite Modus ein Flexionsmodus ist.

3. Resonator nach einem der Ansprüche 1 und 2, dadurch gekennzeichnet, daß er aus einer ebenen Platte aus Quarz ausgeschnitten ist, deren Ebene parallel zur piezoelektrischen Achse X des Quarzes verläuft, wobei die Normale auf die Ebene mit der optischen Achse Z des Quarzes einen Winkel zwischen etwa -10° und +10° einschließt und die Länge der Säulen eine Richtung senkrecht zur Achse X besitzt und dadurch, daß die Erregungsmittel Elektroden umfassen, die auf den Flächen der Säulen angeordnet sind, die parallel zur Achse X verlaufen derart, daß ein elektrisches Feld mit einer Komponenten parallel zur X-Achse erzeugt wird.

4. Resonator nach einem der Ansprüche 1 bis 3, dadurch gekennzeichnet, daß er aus einer ebenen Quarzplatte ausgeschnitten ist, deren Ebene parallel zur piezoelektrischen Achse X des Quarzes verläuft, während die Normale auf die Ebene mit der optischen Z-Achse des Quarzes einen Winkel zwischen 0 und etwa ± 10° einschließt und die Länge der Säulen eine Richtung senkrecht zur Achse X aufweist und dadurch, daß die Erregungsmittel Elektroden umfassen, die auf den Flanken der Säulen senkrecht zur Achse X angeordnet sind zum Erzeugen eines elektrischen Feldes parallel zur Achse X.

5. Resonator nach einem der Ansprüche 1 und 2, dadurch gekennzeichnet, daß er aus einer Platte des Schnittes ZT derart ausgeschnitten ist, daß die Länge der Säulen parallel zur Achse X' der Platte ist und dadurch, daß die Erregungsmittel Elektroden umfassen, die jeweils auf der gesamten Oberfläche einer der Seiten der Säulen angeordnet sind, die parallel zu den Achsen X' und Y' der Platte verlaufen.

6. Resonator nach einem der Ansprüche 3 und 5, dadurch gekennzeichnet, daß die Elektroden sich ferner auf einen Abschnitt der Platten erstrecken.

7. Resonator nach einem der Ansprüche 1 bis 6, dadurch gekennzeichnet, daß er drei parallele Säulen umfaßt.

8. Resonator nach einem der Ansprüche 1 bis 6, dadurch gekennzeichnet, daß er zwei parallele Säulen umfaßt.

**Claims**

1. Piezoelectric resonator comprising two plates, at least two parallel bars connecting the said plates to each other, and means for exciting a vibration of the said resonator in a first contour mode, characterised by the fact that the said means are arranged so as to excite the said vibration in the said bars and that the cut and dimensions of the said resonator are determined so that at least a second contour vibration mode, different from the said first vibration mode, is coupled to the said first vibration mode.

2. Resonator according to claim 1, characterised by the fact that the said first vibration mode is an extension mode and the said second mode is a flexion mode.

3. Resonator according to one of claims 1 and 2, characterised by the fact that it has been cut from a flat quartz plate whose plane is parallel to the piezoelectric axis X of the said quartz, the normal to the said plane forming with the optical axis Z of the said quartz an angle of between - 10° and + 10° approximately and the length of the said bars having a direction perpendicular to the said axis X, and by the fact that the said excitation means comprise electrodes disposed on the faces of the said bars which are parallel to the said axis X so as to produce an electrical field having a component parallel to the said axis X.

4. Resonator according to one of claims 1 to 3, characterised by the fact that it has been cut from a flat quartz plate whose plane is parallel to the piezoelectric axis X of the said quartz, the normal to the said plane forming with the optical axis Z of the said quartz an angle of between 0 and ± 10° approximately and the length of the said bars having a direction perpendicular to the said axis X, and by the fact that the said excitation means comprise electrodes disposed on the sides of the said bars perpendicular to the said axis X for producing an electrical field parallel to the said axis X.

5. Resonator according to one of claims 1 and 2, characterised by the fact that it has been cut from a plate with a ZT cut in such a way that the length of the said bars is parallel to the axis X' of the said plate, and by the fact that the said excitation means comprise electrodes each disposed over the entire surface of one of the faces of the said bars which are parallel to the axes X' and Y' of the said plate.

6. Resonator according to one of claims 3 and 5, characterised by the fact that the said electrodes extend in addition over a part of the said plates.

7. Resonator according to any one of claims 1 to 6, characterised by the fact that it comprises three parallel bars.

8. Resonator according to any one of claims 1 to 6, characterised by the fact that it comprises two parallel bars.

Fig. 1

Fig. 2

Fig.3

Fig.4

Fig.5

*Fig.6*

*Fig.7*

Fig.8